# EUROPÄISCHE PATENTSCHRIFT

(11) **EP 1 080 375 B1**
(45) Veröffentlichungstag und Bekanntmachung des Hinweises auf die Patenterteilung: **23.07.2003**
(21) Anmeldenummer: 99936411.0
(22) Anmeldetag: 28.05.1999
(51) Int. Cl.: G01R 33/09

(54) **MAGNETFELDSENSOR**
MAGNETIC FIELD SENSOR
DETECTEUR DE CHAMP MAGNETIQUE

(30) Priorität: 28.05.1998 DE 19825392
(43) Veröffentlichungstag der Anmeldung: 07.03.2001
(73) Patentinhaber: Hahn-Meitner-Institut Berlin Gesellschaft mit beschränkter Haftung, 14109 Berlin (DE)
(72) Erfinder: NAWRATH, Thorsten, D-24768 Rendsburg (DE); FRITZSCHE, Helmut, D-14057 Berlin (DE); MALETTA, Hansjörg, D-14199 Berlin (DE); NOWIKOW, Jan, D-10437 Berlin (DE)
(74) Vertreter: Hoffmann, Heinz-Dietrich
(86) Internationale Anmeldenummer: DE9901643
(87) Internationale Veröffentlichungsnummer: WO99061930

(56) Entgegenhaltungen:
- EP-A- 0 727 773
- US-A- 5 014 147
- US-A- 5 373 238
- US-A- 5 919 580

## Beschreibung

Die Erfindung betrifft einen Magnetfeldsensor, der aus einer Schichtenfolge von mindestens zwei ferromagnetischen Schichten besteht, die durch eine unmagnetische Schicht voneinander getrennt sind, wobei eine der ferromagnetischen Schichten als Referenzschicht dient und die unmagnetische Schicht so dünn ausgebildet ist, daß die Information über dierelative Magnetisierungsrichtung der beiden ferromagnetischen Schichten zueinander in Form von spinpolarisierten Leitungselektronen übertragbar ist.

Derartige Magnetfeldsensoren beruhen auf dem bekannten Effekt; daß ein Schichtpaket aus zwei ferromagnetischen Schichten, die durch eine leitende unmagnetische Schicht voneinander getrennt sind, einen hohen elektrischen Widerstand aufweist, wenn die Magnetisierungsrichtungen der beiden ferromagnetischen Schichten antiparallel zueinander ausgerichtet sind und einen niedrigen Widerstand bei paralleler Ausrichtung in beiden Schichten. Erklären läßt sich dieser Effekt durch eine spinabhängige Elektrohenstreuung in den ferromagnetischen Schichten, die durch eine unterschiedlich starke Reflexion der Elektronen mit "spin auf" (spin parallel zur Magnetisierung) und "spin ab" (spin antiparallel zur Magnetisierung) an den inneren Grenzflächen der ferromagnetischen Schichten zustande kommt. Voraussetzung für das Auftreten dieses Effektes ist es, daß die Magnetisierungen der ferromagnetischen Schichten in Abhängigkeit von einem äußeren Magnetfeld aus einer antiparallelen in eine parallele Stellung wechseln. Als Auswirkung hieraus ergibt sich eine Beeinflußbarkeit des Magnetowiderstandes, d.h. des elektrischen Widerstandes des Sensorschichtpaketes durch äußere Magnetfelder. Das bedeutet, daß äußere Magnetfelder in Abhängigkeit von einer entsprechenden Änderung des Sensorwiderstandes detektiert werden können. Der Effekt der Widerstandsänderung benachbarter ferromagnetischer Schichten bei Änderung der Magnetisierungsrichtungen zwischen diesen Schichten von parallel zu antiparallel bzw. umgekehrt wird in der Fachliteratur als GMR (Giant Magneto Resistance) bzw. Riesenmagnetowiderstand bezeichnet, der mit oder auch ohne Austauschkopplung der ferromagnetischen Schichten über nichtmagnetische Zwischenschichten zustande kommen kann. Ein GMR-Schichtsystem ist in Baibich et al., Phys. Rev. Lett., Vol. 61, Nr. 21, S. 2472-2475, beschrieben. Im Falle eines GMR-Effekts ohne Austauschkopplung wird in der Literatur auch die Bezeichnung "Spin-Valve"-System (Spin-Ventil-System) verwendet (vgl. Grünberg, P. "Riesenmagnetowiderstand in magnetischen Schichtstrukturen", Phys. Bl. 51 (1995) Nr. 11 S. 1077-1081). Ein solcher Spin-Valve-Magnetfeldsensor ist zum Beispiel in der amerikanischen Patentschrift US 5 373 238 A beschrieben. Die Widerstandsänderung bei einem realisierten GMR-Magnetfeldsensor beträgt beispielsweise ≈ 70 % bei typischen Sättigungsfeldem von 1 bis 2 T. Das Sättigungsfeld ist hierbei das Feld, bei dem ein Umschalten von paralleler zu antiparalleler Magnetisierungsstellung erfolgt. Ein Spin-Valve-Magnetfeldsensor weist hingegen eine Widerstandsänderung von ≈ 10 % auf bei einwirkenden äußeren Magnetfeldern von 2m T. Der Effekt der Widerstandsänderung ist demnach bei einem Spin-Valve-Sensor relativ zum angelegten (detektierten) Magnetfeld deutlich höher. Die kleinere Widerstandsänderung in Relation zum angelegten Magnetfeld schränkt daher das Anwendungsgebiet eines GMR-Magnetfeldsensors auf Bereiche ein, in denen Magnetfelder von großer Stärke detektiert werden sollen. Ein universeller Einsatz derartiger Sensoren ist daher nicht sinnvoll. Ein weiterer Nachteil bei GMR-Magnetfeldsensoren besteht in der erforderlichen hohen Genauigkeit für die Schichtdicken nichtmagnetischer Zwischenschichten. Dies bedingt sehr hohe Ansprüche an die Fertigungsgenauigkeit des Sensors. Bei Spin-Valve-Magnetfeldsensoren ist eine nach ca. 5•10⁴ Umschaltvorgängen auftretende Ermüdung als nachteilig anzusehen. Nachteilig ist weiterhin, daß bei Spin-Valve-Sensoren die Schaffung eines Mehrniveausensors nicht möglich ist, der mehrere Umschaltfelder für einzelne ferromagnetische Schichten und damit auch mehrere Widerstandsniveaus aufweist.

Aufgabe der Erfindung ist es, einen Magnetfeldsensor der eingangs genannten Art so auszubilden, daß er einmal eine sehr große Lebensdauer aufweist und zum anderen für die Detektierung sowohl großer als auch kleiner Magnetfelder geeignet ist und die Möglichkeit zum Bau eines Mehrniveausensors bietet.

Die Aufgabe wird bei einem Magnetfeldsensor, der mindestens zwei ferromagnetische Schichten aufweist, erfindungsgemäß dadurch gelöst, daß die zweite der ferromagnetischen Schichten (die erste dient in bekannter Weise als Referenzschicht) eine Schicht aus einem aus mehreren atomaren Monolagen bestehenden antiferromagnetischen Material trägt, diese antiferromagnetische Schicht eine kubisch raumzentrierte Struktur und vorzugsweise eine Kristallorientierung in (110)-Richtung aufweist, wobei die magnetischen Momente in den einzelnen. Monolagen in sich antiferromagnetisch ausgerichtet sind und die antiferromagnetische Schicht eine derartige Dicke aufweist, daß eine magnetische Wechselwirkung mit der benachbarten ferrromagnetischen Schicht erfolgt, wodurch es zu einer Erhöhung der Koerzitivfeldstärke dieser ferromagnetischen Schicht kommt.

Die erfindungsgemäße Lösung beruht auf einem neuen physikalischen Effekt, bei dem die Koerzitivkraft einer ferromagnetischen Schicht über eine benachbarte Schicht aus antiferromagnetischen Materialien, die eine bestimmte Kristallorientierung aufweisen, gezielt erhöht werden kann. Die Dicke der antiferromagnetischen Schicht sollte vorteilhafterweise größer als 2 nm sein und liegt vorzugsweise in einem Bereich zwischen 2 nm und 12 nm. Sie besteht aus Cr, Mn oder einer antiferromagnetischen Legierung. Für die Schaffung eines Mehrniveausensors kann der Grundaufbau des Sensors variiert werden, indem man mehrere ferromagnetische Schichten vorsieht, die jeweils durch eine unmagnetische Schicht voneinander getrennt sind und jeweils eine antiferromagnetische Nachbarschicht von verschiedener Dicke besitzen, wobei jede der ferromagnetischen Schichten als Referenzschicht für die nächstfolgende ferromagnetische Schicht dient.

Der erzielbare Effekt der Widerstandsänderung im Magnetfeldsensor kann in zwei unterschiedlichen Ebenen gemessen werden. Einmal mit dem Stromfluß parallel zu den Schichtebenen CiP-(Current in Plane)-Geometrie und zum anderen mit dem Stromfluß senkrecht zu den Schichtebenen, die als CPP-(Current Perpendicular Plane)-Geometrie bezeichnet wird. Für die CiP-Geometrie spricht, daß keine Strukturierung der Schichten erforderlich ist. Dafür ist in der CPP-Geometrie der erzielte Effekt wesentlich größer.

Das durch den Magnetfeldsensor detektierte Magnetfeld liegt vorzugsweise parallel zu den Schichtebenen des Sensors. Dies ist dadurch bedingt, daß die Drehung der Magnetisierung in bzw. parallel zu den Schichtebenen leicht zu realisieren ist. Eine Drehung des Magnetfeldes beispielsweise senkrecht zu den Schichtebenen würde einen wesentlich höheren Energieaufwand erfordern.

Die kristalline Struktur der ferromagnetischen Schichten des erfindungsgemäßen Sensors kann unterschiedlich sein. Bei einer einkristallinen Struktur der ferromagnetischen Schichten, bei der die Magnetisierungsrichtungen der einzelnen ferromagnetischen Schichten aufgrund einer uniaxialen Symmetrie nur entlang einer Richtung in Schichtebene zeigen spricht der Sensor nur auf Magnetfeldkomponenten in bzw. parallel zu dieser Richtung an. Weisen die ferromagnetischen Schichten eine polykristalline Struktur auf, spricht der Sensor auf alle Magnetfelder an, die in Schichtebene verlaufen.

Die Erfindung wird nachfolgend an Ausführungsbeispielen anhand der zugehörigen Zeichnung näher erläutert.
Es zeigen:
- Fig. 1:: Ein Diagramm das die Abhängigkeit der Koerzitivkraft H_{C} einer ferromagnetischen Schicht von der Dicke einer zugehörigen antiferrromagnetischen Schicht zeigt,
- Fig. 2:: den grundlegenden Schichtaufbau eines erfndungsgemäßen Magnetfeldsensors,
- Fig. 3:: den Magnetisierungsverlauf des in Fig. 2 dargestellten Schichtpakets eines Magnetfeldsensors über der äußeren Feldstärke H, bei großen Werten von H,
- Fig. 4:: den Widerstandsverlauf im Magnetfeldsensor über der äußeren (detektierten) Feldstärke H, die kleiner ist als die Koerzitivfeldstärke H_{C2} einer FM2-Schicht,
- Fig. 5a, b:: Varianten der Schichtenfolgen eines erfindungsgemäßen Sensors für mehrere Niveaus.

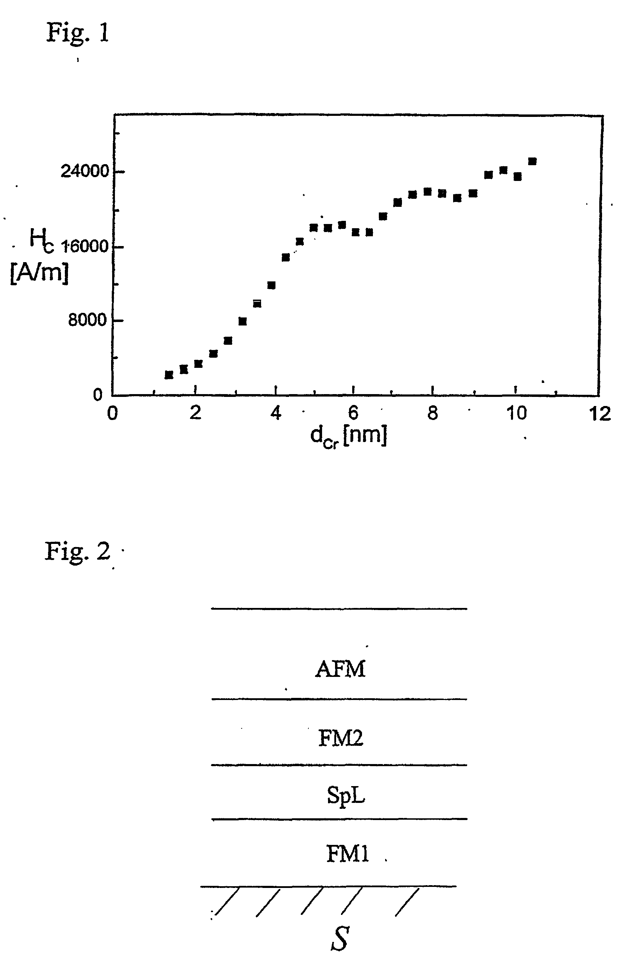

In Fig. 1 ist dargestellt, wie sich die Größe der Koerzitivkraft **H**_{**C**} einer ferromagnetischen Schicht durch die Variation der Dicke **d**_{**cr**} einer benachbarten antiferromagnetischen Schicht aus Chrom beeinflussen läßt. Es ist ersichtlich, daß im Dickenbereich zwischen 2 nm und 4 nm ein sehr steiler Anstieg erfolgt, während ab einer Dicke von 5 nm und darüber der mittlere Anstieg moderater verläuft.

In Fig. 2 ist das Schema des grundlegenden Aufbaus eines erfindungsgemäßen Magnetfeldsensors gezeigt. Auf einem Substrat S befindet sich eine erste ferromagnetische Schicht **FM1** als Referenzschicht, ihr folgt eine unmagnetische Spin-Leiter-Schicht **SpL** und anschließend eine zweite ferromagnetische Schicht **FM2**. Auf dieser befindet sich die antiferromagnetische Schicht **AFM**, über deren Dicke die Koerzitivkraft **H**_{**C**} in der **FM2**-Schicht beeinflußbar ist.

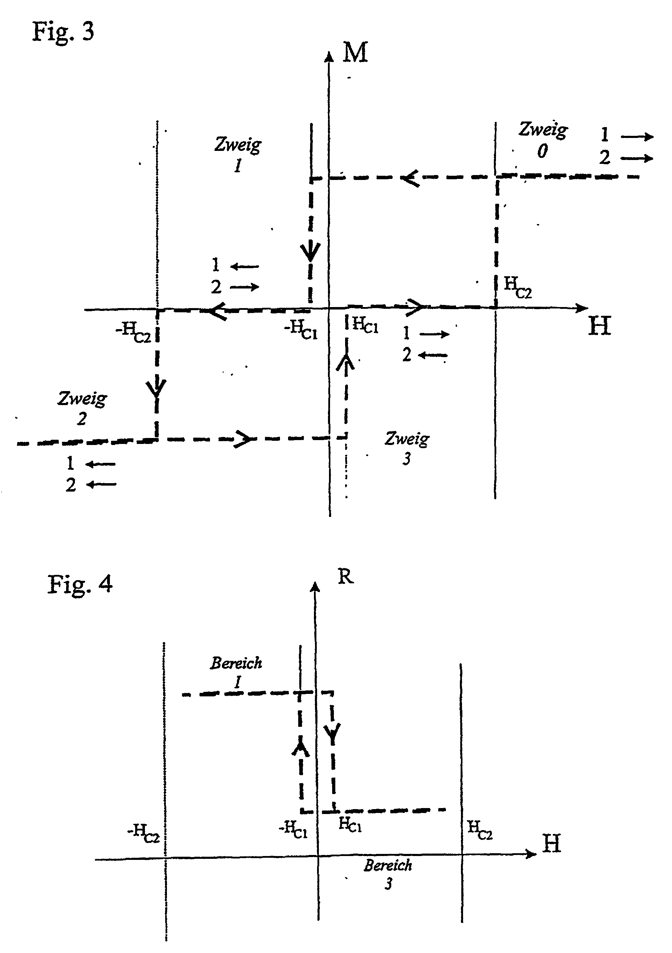

In Fig. 3 ist der Magnetisierungsverlauf des in Fig. 2 dargestellten Schichtpakets skizziert, wenn man einen Feldbereich durchfährt, der größer als die Koerzitivfelder **H**_{**C1**} und **H**_{**C2**} der beiden ferromagnetischen Schichten ist. Das Feld wird zuerst von positiven Werten zu negativen Werten hin durchgefahren, danach fährt man das Feld wieder auf seinen Ausgangspunkt zurück. Die Magnetisierung verläuft dabei entlang der eingezeichneten Pfeile. Wichtig sind hierbei die Teilabschnitte, die als Zweig 0-3 gekennzeichnet sind. Im Zweig 0 stehen die Magnetisierungen beider Schichten in Feldrichtung (positive Magnetisierung). Im Zweig 1 ist **FM1** bereits wieder in Feldrichtung geklappt, die Schichten stehen antiparallel. Im Zweig 2 stehen wieder beide Magnetisierungen in Feldrichtung (negative Magnetisierung). Im Zweig 3 stehen die Schichten **FM1** und **FM2** wieder antiparallel. Für den Betrieb wird ein moderater Feldbereich gewählt **(-H**_{**C2**}**<H<H**_{**C2**}**),** in dem nur die Magnetisierung der Schicht **FM1** umklappt. Diese steht dadurch wechselweise parallel und antiparallel zur Schicht **FM2.** Daraus ergibt sich ein Widerstandsverlauf, wie in Fig. 4 skizziert, der vom äußeren Feld abhängig ist. In Fig. 4 wird der Betrieb des Sensors für einen Feldbereich **H,** der kleiner als das Koerzitivfeld **H**_{**C2**} der **FM2**-Schicht ist, demonstriert. Aufgrund des im Vergleich zu Fig. 3 kleineren Feldbereichs wird nur die Magnetisierung der **FM1**-Schicht eingeschaltet. Die Magnetisierung der **FM2**-Schicht steht dabei so wie in Zweig 0 von Fig. 3. (Ein Betrieb mit der Magnetisierung von **FM2** wie im Zweig 2 ist ebenfalls möglich. Dies bewirkt eine Spiegelung von Fig.4 entlang der R-Achse). Im Bereich 1 hat der Sensor demnach einen hohen Widerstand, da die Magnetisierung der **FM1**-Schicht in die (negative) Feldrichtung geklappt ist und damit antiparallel zur **FM2**-Schicht steht. Im Bereich 3 liegt eine parallele Ausrichtung der **FM1-** und **FM2**-Schichten vor. Der Widerstand (des Sensors) ist dadurch geringer.

Anders als beim Spin-Valve Sensor läßt sich dieses Funktionsprinzip auf ein Schichtpaket mit drei, vier usw. magnetischen Schichten erweitern, bei verschiedenen **H**_{**C**}**'s** läßt sich dadurch ein magnetischer Drei-, Vier- ..Niveausensor realisieren.

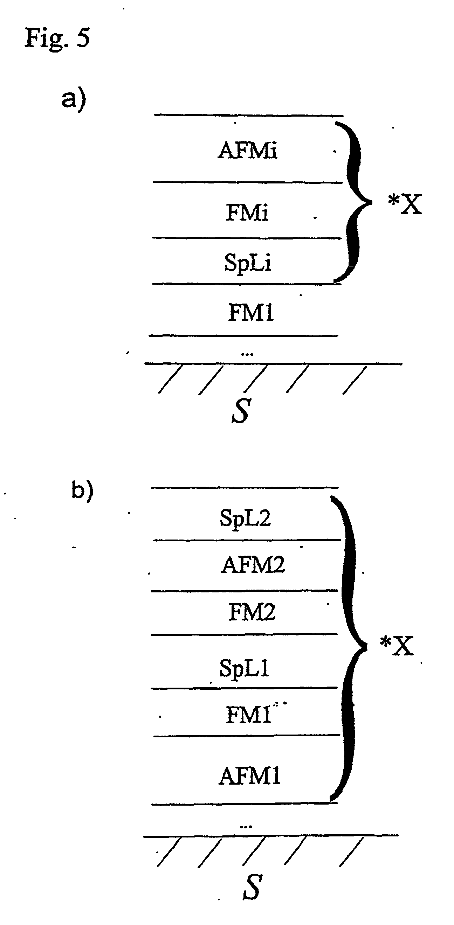

In Fig. 5a und 5b sind die Varianten der Schichtenfolgen eines erfindungsgemäßen Magnetfeldsensors für mehrere Niveaus dargestellt. Gemäß Fig. 5a ist auf einem Substrat **S** zunächst eine ferromagnetische Schicht **FM1** aufgebracht, darüber eine unmagnetische Spin-Leiter-Schicht **SpL**_{**i**}**.** Ihr folgt eine ferromagnetische Schicht **FM**_{**i**} und eine antiferromagnetische Schicht **AFM**_{**i**}**.** Wird dieses Schichtpaket ab der Schicht' **SpL**_{**i**} vervielfacht (Faktor X), so erhält man **H**_{**C1**}**.....H**_{**CX**} und kann so einen Mehrniveausensor realisieren. Die Schichtenfolge nach Fig. 5b beginnt mit einer ersten antiferromagnetischen Schicht **AFM1,** darüber eine erste ferromagnetische Schicht **FM1,** der eine erste unmagnetische Spin-Leiter-Schicht **SpL1** folgt. Es folgen nun die jeweils zweiten Schichten in der Reihenfolge **FM2, AFM2** und **SpL2.** Die Vervielfachung dieser Schichtenfolge ergibt wieder einen Mehr-Niveausensor. die Vor- und Nachteile beider Varianten werden nachstehen erläutert:
Beim Bau eines magnetoresistiven Sensors nach dem GMR-Prinzip muß gesichert sein, daß die Spininformation, die durch Leitungselektronen über die unmagnetische Zwischenschicht bzw. das Zwischenschichtpaket aus **SpL-** und **AFM**-Schicht übertragen wird, nicht verloren geht. Der Verlust der Spininformation wird dabei i.a. durch Streuprozesse in der Zwischenschicht hervorgerufen. Je weniger Streuprozesse in der Zwischenschicht stattfinden, desto höher ist der Anteil an Leitungselektronen, die die Spininformation zwischen der **FM1-** und der **FM2**-Schicht übertragen und desto höher ist damit auch die feldabhängige Änderung des Sensorwiderstands.
Die feldabhängige Änderung des Sensorwiderstands kann demnach sowohl durch eine relativ dicke Zwischenschicht als auch durch einen hohen spezifischen elektrischen Widerstand in der Zwischenschicht herabgesetzt werden, da sich in beiden Fällen die Anzahl der gestreuten Elektronen erhöht.

Während der elektrische Widerstand in der Zwischenschicht in der Regel durch den Herstellungsprozeß vorgegeben ist und nur wenig beeinflußt werden kann, ergibt sich jedoch im vorliegenden Fall die Möglichkeit, die Dicke der Zwischenschicht (des Zwischenschichtpakets) zu verkleinern. Hieraus ergeben sich zwei alternative Schichtenfolgen entspr. Fig. 5a und 5b. Bei der Schichtenfolge nach Fig. 5a hat man jeweils Schichtpakete aus einer **AFM-,** einer **FM-** und einer **SpL**-Schicht, wobei die Koerzitivkraft des Schichtpakets jeweils durch die Dicke der **AFM**-Schicht bestimmt ist. Der Abstand zwischen den **FM**-Schichten in zwei benachbarten Schichtpaketen ergibt sich hierbei aus der Dicke der jeweiligen **AFM-** und SpL-Zwischenschichten. Diese Schichtenfolge hat den Vorteil, daß jede **FM**-Schicht zwei benachbarte **FM**-Schichten hat, deren relative Magnetisierungsausrichtung bezüglich der ersten Schicht über die Größe des Gesamtwiderstandes im Sensor entscheidet Nachteilig für den Gesamteffekt kann sich hierbei jedoch der relativ große Abstand zwischen den jeweils benachbarten **FM**-Schichten auswirken. Dieser Nachteil tritt bei der Schichtenfolge gemäß Fig. 5b nicht auf, da dort jeweils zwei **FM**-Schichten in einem Schichtpaket nur durch eine **SpL**-Schicht voneinander getrennt sind. Ein Wechsel zwischen einer parallelen und einer antiparallelen Ausrichtung der Magnetisierung zwischen diesen benachbarten **FM-**Schichten hat einen großen Einfluß auf den Gesamtwiderstand des Sensors. Andererseits sind diese beiden **FM**-Schichten wiederum relativ weit von den **FM**-Schichten im benachbarten Schichtenpaket entfernt, wodurch eine stärkere Isolation von der Spinstellung dieser **FM**-Schichten im Nachbar-Schichtpaket erfolgt. In Abhängigkeit vom herstellungstechnisch realisierten Widerstand in den **AFM-** und **SpL**-Schichten kann eine Schichtenfolge nach Fig. 5a oder Fig. 5b vorteilhaft sein. Hierbei sind auch weitere Schichtenfolgen, die auf den hier vorgebrachten Überlegungen aufbauen, denkbar.

Für die Realisierung einer bestimmten atomaren Struktur der einzelnen Schichten kann es erforderlich sein, zwischen dem Substrat **S** und der ersten **FM**- bzw. **AFM**-Schicht eine Übergangsschicht einzubauen. Diese Möglichkeit ist in Fig. 5a und Fig. 5b durch eine Lücke zwischen dem Substrat **S** und der **FM1**- bzw. der **AFM1**-Schicht schon angedeutet. Diese Übergangsschicht ist wichtig für das epitaktische Aufwachsen der einzelnen Schichten. Ihr Material ist abhängig von Substratmaterial, Das Substrat muß elektrisch neutral sein und kann beispielsweise aus **Al**_{**2**}**O**_{**3**}, **Si**, **MgO** oder **GaAs** bestehen. Weiterhin kann es sinnvoll sein, als oberen Abschluß des gesamten Schichtenpakets eine Deckschicht vorzusehen. Diese dient als Oxidationsschutz und Schutz vor mechanischer Beanspruchung.

## Patentansprüche

1. Magnetfeldsensor, bestehend aus einer Schichtenfolge von mindestens zwei ferromagnetischen Schichten (FM1, FM2, FMi), die durch eine unmagnetische Schicht voneinander getrennt sind, die so dünn ist, daß die Information über die relative Magnetisierungsrichtung der beiden ferromagnetischen Schichten zueinander in Form von spinpolarisierten Leitungselektronen übertragbar ist, wobei eine erste ferromagnetische Schicht (FM1) als Referenzschicht dient und wobei eine zweite ferromagnetische (FM2) eine antiferromagnetische Schicht (AFM) trägt,
**dadurch gekennzeichnet, daß**
die antiferromagnetische Schicht (AFM) aus einem aus mehreren atomaren Monolagen bestehenden antiferromagnetischen Material besteht, diese antiferromagnetische Schicht eine kubisch raumzentrierte Struktur und eine Kristallorientierung in (110)-Richtung aufweist, wobei die einzelnen magnetischen Momente in jeder Monolage zueinander antiferromagnetisch ausgerichtet sind und diese antiferromagnetische Schicht (AFM) eine derartige Dicke aufweist, daß eine magnetische Wechselwirkung mit der benachbarten ferromagnetischen Schicht (FM2) erfolgt, die zu einer Erhöhung der Koerzitivfeldstärke dieser ferromagnetischen Schicht führt, wobei über die Dicke der antiferromagnetischen Schicht (AFM) die Koerzitivfeldstärke dieser ferromagnetischen Schicht (FM2) über einen Bereich zwischen 200 A/m und 25000 A/m einstellbar ist.

2. Magnetfeldsensor nach Anspruch 1,
**dadurch gekennzeichnet, daß**
die Dicke (d) der antiferromagnetischen Schicht (AFM) > 2 nm beträgt.

3. Magnetfeldsensor nach Anspruch 1,
**dadurch gekennzeichnet, daß**
die Dicke (d) der antiferromagnetischen Schicht (AFM) vorzugsweise in einem Bereich von 2 nm < d < 12 nm liegt.

4. Magnetfeldsensor nach Anspruch 1,
**dadurch gekennzeichnet, daß**
die antiferromagnetische Schicht (AFM) aus Cr, Mn oder einer antiferromagnetischen Legierung besteht.

5. Magnetfeldsensor nach Anspruch 1,
**dadurch gekennzeichnet, daß**
dieser als Mehrniveausensor ausgebildet ist, der neben der ersten ferromagnetische Schicht (FM1) mehrere ferromagnetische Schichten (FMᵢ) aufweist, wobei die ferromagnetischen Schichten (FM1, FMᵢ) jeweils durch eine unmagnetische Schicht (SpLᵢ) voneinander getrennt sind und jede der ferromagnetischen Schichten (FMᵢ) eine antiferromagnetische Nachbarschicht (AFMᵢ) *von verschiedener Dicke* trägt, wobei jede der ferromagnetischen Schichten (FMᵢ) als Referenzschicht für die nächstfolgende ferromagnetische Schicht (FMᵢ) dient und mindestens zwei der ferromagnetischen Schichten (FMᵢ) unterschiedliche Koerzitivfelder aufweisen.

6. Magnetfeldsensor nach Anspruch 1,
**dadurch gekennzeichnet, daß**
dieser als Mehrniveausensor ausgebildet ist, der aus mehreren Schichtpaketen aufgebaut ist, wobei jedes Schichtpaket jeweils zwei ferromagnetische Schichten (FM1, FM2) aufweist, die durch eine unmagnetische Schicht (SpL1) voneinander getrennt sind und die ferromagnetischen Schichten (FM1, FM2) jeweils eine antiferromagnetische Nachbarschicht (AFM1, AFM2) *von verschiedener Dicke* tragen und mindestens zwei der ferromagnetischen Schichten (FM1, FM2) unterschiedliche Koerzitivfelder aufweisen.

7. Magnetfeldsensor nach Anspruch 1,
**dadurch gekennzeichnet, daß**
die Stromrichtung bei der Messung der Widerstandsänderung im Magnetfeldsensor parallel zu den Schichtebenen verläuft.

8. Magnetfeldsensor nach Anspruch 1,
**dadurch gekennzeichnet, daß**
die Stromrichtung bei der Messung der Widerstandsänderung im Magnetfeldsensor senkrecht zu den Schichtebenen verläuft.

9. Magnetfeldsensor nach Anspruch 1,
**dadurch gekennzeichnet, daß**
der Magnetfeldsensor derart ausgerichtet ist, daß das zu detektierende Magnetfeld vorzugsweise parallel zu den Schichtebenen verläuft.

10. Magnetfeldsensor nach Anspruch 1,
**dadurch gekennzeichnet, daß**
dieser eine einkristalline Struktur aufweist und die Magnetisierungsrichtungen der einzelnen ferromagnetischen Schichten aufgrund einer uniaxialen Symmetrie nur entlang einer Richtung in der Schichtebene zeigen, so daß der Sensor nur auf die Magnetfeldkomponente in dieser Richtung anspricht.

11. Magnetfeldsensor nach Anspruch 1,
**dadurch gekennzeichnet, daß**
dieser eine polykristalline Struktur aufweist, so daß er auf alle Magnetfelder, die in Schichtebene verlaufen, anspricht.

## Claims

1. Magnetic field sensor, consisting of a layer sequence of at least two ferromagnetic layers (FM1, FM2, FMᵢ), which are separated from each other by a non-magnetic layer which is so thin that the information about the relative magnetisation direction of the two ferromagnetic layers can be transmitted to each other in the form of spin-polarised conduction electrons, a first ferromagnetic layer (FM1) being used as a reference layer and a second ferromagnetic (FM2) carrying an anti-ferromagnetic layer (AFM),
**characterized in that**
the anti-ferromagnetic layer (AFM) consists of anti-ferromagnetic material which consists of multiple atomic monolayers, this anti-ferromagnetic layer has a cubically space-centred structure and crystal orientation in the (110) direction, the individual magnetic moments in each monolayer being aligned anti-ferromagnetically to each other, and this anti-ferromagnetic layer (AFM) having such a thickness that a mutual magnetic effect with the adjacent ferromagnetic layer (FM2) occurs, resulting in an increase of the coercive field strength of this ferromagnetic layer, it being possible to adjust the coercive field strength of this ferromagnetic layer (FM2) over a range between 200 A/m and 25000 A/m via the thickness of the anti-ferromagnetic layer (AFM).

2. Magnetic field sensor according to Claim 1,
**characterized in that**
the thickness (d) of the anti-ferromagnetic layer (AFM) is > 2 nm.

3. Magnetic field sensor according to Claim 1,
**characterized in that**
the thickness (d) of the anti-ferromagnetic layer (AFM) is preferably in a range from 2 nm < d < 12 nm.

4. Magnetic field sensor according to Claim 1,
**characterized in that**
the anti-ferromagnetic layer (AFM) consists of Cr, Mn or an anti-ferromagnetic alloy.

5. Magnetic field sensor according to Claim 1,
**characterized in that**
this is in the form of a multiple-level sensor, which as well as the first ferromagnetic layer (FM1) has multiple ferromagnetic layers (FMᵢ), the ferromagnetic layers (FM1, FMᵢ) being separated from each other by a non-magnetic layer (SPLᵢ) and each of the ferromagnetic layers (FMᵢ) having an adjacent anti-ferromagnetic layer (AFMᵢ) of different thickness, each of the ferromagnetic layers (FMᵢ) being used as a reference layer for the next ferromagnetic layer (FMᵢ), and at least two of the ferromagnetic layers (FMᵢ) having different coercive fields.

6. Magnetic field sensor according to Claim 1,
**characterized in that**
this is in the form of a multiple-level sensor, which is constructed out of multiple layer packages, each layer package having two ferromagnetic layers (FM1, FM2), which are separated from each other by a non-magnetic layer (SpL1), and the ferromagnetic layers (FM1, FM2) each carrying an adjacent anti-ferromagnetic layer (AFM1, AFM2) of different thickness, and at least two of the ferromagnetic layers (FM1, FM2) having different coercive fields.

7. Magnetic field sensor according to Claim 1,
**characterized in that**
the current direction for the measurement of the resistance change in the magnetic field sensor runs parallel to the layer planes.

8. Magnetic field sensor according to Claim 1,
**characterized in that**
the current direction for the measurement of the resistance change in the magnetic field sensor runs vertical to the layer planes.

9. Magnetic field sensor according to Claim 1,
**characterized in that**
the magnetic field sensor is aligned in such a way that the magnetic field to be detected preferably runs parallel to the layer planes.

10. Magnetic field sensor according to Claim 1,
**characterized in that**
this has a monocrystalline structure, and the magnetisation directions of the individual ferromagnetic layers, because of a uniaxial symmetry, show only along one direction in the layer plane, so that the sensor responds only to the magnetic field component in this direction.

11. Magnetic field sensor according to Claim 1,
**characterized in that**
this has a polycrystalline structure, so that it responds to all magnetic fields which run in the layer plane.

## Revendications

1. Détecteur de champ magnétique composé d'une succession de couches comprenant au moins deux couches ferromagnétiques (FM1, FM2, FMᵢ) séparées les unes des autres par une couche amagnétique tellement mince que les informations concernant la direction d'aimantation relative des deux couches ferromagnétiques peuvent être transmises l'une à l'autre sous la forme d'électrons conducteurs à spin polarisé,
une première couche ferromagnétique (FM1) servant de couche de référence et une seconde couche ferromagnétique (FM2) portant une couche antiferromagnétique (AFM),
**caractérisé en ce que**
la couche antiferromagnétique (AFM) se compose d'une matière antiferromagnétique formée de plusieurs monocouches atomiques,
cette couche antiferromagnétique ayant une structure cubique centrée et une orientation cristallographique dans la direction (110),
les différents moments magnétiques de chaque monocouche étant alignés de manière antiferromagnétique les uns par rapport aux autres, et
cette couche antiferromagnétique (AFM) a une épaisseur telle que l'on a une coopération magnétique avec la couche ferromagnétique voisine (FM2) qui conduit à une augmentation du champ coercitif de cette couche ferromagnétique,
l'intensité du champ coercitif de cette couche ferromagnétique (FM2) étant réglable par l'épaisseur de la couche antiferromagnétique (AFM) dans une plage comprise entre 200 A/m et 25000 A/m.

2. Détecteur de champ magnétique selon la revendication 1,
**caractérisé en ce que**
l'épaisseur (d) de la couche antiferromagnétique (AFM) > 2 nm.

3. Détecteur de champ magnétique selon la revendication 1,
**caractérisé en ce que**
l'épaisseur de la couche antiferromagnétique (AFM) est de préférence comprise dans une plage telle que 2 nm < d < 12 nm.

4. Détecteur de champ magnétique selon la revendication 1,
**caractérisé en ce que**
la couche antiferromagnétique est formée de Cr, Mn ou d'un alliage antiferromagnétique.

5. Détecteur de champ magnétique selon la revendication 1,
**caractérisé en ce qu'**
il est réalisé comme détecteur à plusieurs niveaux qui comporte à côté de la première couche ferromagnétique (FM1), plusieurs couches ferromagnétiques (FMᵢ), les couches ferromagnétiques (FM1, FMᵢ) étant séparées chaque fois les unes des autres par une couche amagnétique (SpLᵢ), et
chaque couche ferromagnétique (FMᵢ) porte une couche voisine antiferromagnétique (AFMᵢ) d'épaisseur différente,
et chacune des couches ferromagnétiques (FMᵢ) sert de couche de référence pour la couche de référence suivante (FMᵢ) et au moins deux des couches ferromagnétiques (FMᵢ) ont des champs coercitifs différents.

6. Détecteur de champ magnétique selon la revendication 1,
**caractérisé en ce qu'**
il est réalisé comme détecteur à plusieurs niveaux formé de plusieurs paquets de couches,
chaque paquet de couches ayant chaque fois deux couches ferromagnétiques (FM1, FM2) séparées respectivement par une couche amagnétique (SpL1) et
les couches ferromagnétiques (FM1, FM2) portent chaque fois une couche voisine antiférromagnétique (AFM1, AFM2) d'épaisseur différente et au moins deux couches ferromagnétiques (FM1, FM2) ont des champs coercitifs différents.

7. Détecteur de champ magnétique selon la revendication 1,
**caractérisé en ce que**
la direction du courant lors de la mesure de la variation de résistance dans le détecteur de champ magnétique se fait parallèlement au plan des couches.

8. Détecteur de champ magnétique selon la revendication 1,
**caractérisé en ce que**
la direction du courant lors de la mesure de la variation de résistance dans le détecteur de champ magnétique est perpendiculaire au plan des couches.

9. Détecteur de champ magnétique selon la revendication 1,
**caractérisé en ce que**
le détecteur de champ magnétique est aligné pour que le champ magnétique à détecter soit de préférence parallèle au plan des couches.

10. Détecteur de champ magnétique selon la revendication 1,
**caractérisé par**
une structure monocristalline, et des directions d'aimantation des différentes couches ferromagnétiques dirigées seulement le long d'une direction dans le plan de la couche du fait d'une symétrie uniaxiale, de sorte que le détecteur ne répond qu'à la composante de champ magnétique dans cette direction.

11. Détecteur de champ magnétique selon la revendication 1,
**caractérisé par**
une structure polycristalline de façon à répondre à tous les champs magnétiques situés dans le plan de la couche.
